# EUROPÄISCHE PATENTSCHRIFT

(11) **EP 0 416 350 B1**
(45) Veröffentlichungstag und Bekanntmachung des Hinweises auf die Patenterteilung: **19.07.1995**
(21) Anmeldenummer: 90115790.9
(22) Anmeldetag: 17.08.1990
(51) Int. Cl.: G11C 8/00, G11C 7/00, G11C 8/04

(54) **Schaltungsanordnung für Fernmeldevermittlungsanlagen, insbesondere Fernsprechvermittlungsanlagen, mit mittels Adressen ansteuerbaren Schaltelementen umfassenden Schalteinrichtungen**
Circuit arrangement for telecommunication exchanges, in particular telephone exchanges, with switching devices having address controlled switching elements
Circuit pour centraux de télécommunication, en particulier centraux téléphoniques avec des dispositifs de commutation comprenant des éléments de commutation commandés par des adresses

(30) Priorität: 08.09.1989 DE 3930008
(43) Veröffentlichungstag der Anmeldung: 13.03.1991
(73) Patentinhaber: SIEMENS AKTIENGESELLSCHAFT, 80333 München (DE)
(72) Erfinder: Pöhnitzsch, Günter, Dipl.-Ing., D-8000 München 61 (DE)

(56) Entgegenhaltungen:
- EP-A- 0 174 845

## Beschreibung

Die Erfindung betrifft eine Schaltungsanordnung für Fernmeldevermittlungsanlagen, insbesondere Fernsprechvermittlungsanlagen, mit jeweils eine Vielzahl von mittels Adressen ansteuerbaren, insbesondere koordinatenförmig angeordneten Schaltelementen umfassenden Schalteinrichtungen, die jeweils eine Adresse über einen Eingang nacheinander in zwei Hälften in einer einer ersten Hälfte entsprechenden ersten Zeitlage und in einer einer zweiten Hälfte entsprechenden zweiten Zeitlage aufnehmen, und die jeweils die in der ersten Zeitlage aufgenommene erste Hälfte wenigstens bis zur zweiten Zeitlage zwischenspeichern, und in denen bei anschließendem Empfang der zweiten Hälfte mittels dieser und der zwischengespeicherten ersten Hälfte die Ansteuerung des betreffenden Schaltelementes gemäß der Adresse erfolgt, und die bei einer Serien-Ansteuerung nacheinander von mehreren Schaltelementen, die sich bei gleichbleibendem Inhalt der ersten Adressenhälfte nur durch den Inhalt der jeweils zweiten Adressenhälfte unterscheiden, eine diese Serien-Ansteuerung anzeigende Zusatz-Information, sowie von denjenigen Adressen, die zu einer Serien-Ansteuerung gehören, nur die jeweilige zweite Adressenhälfte erhalten und durch diese Zusatz-Infomation veranlaßt werden, die erste Hälfte der bei dieser Serien-Ansteuerung aufgenommenen Adresse über die erste Ansteuerung bei dieser Serien-Ansteuerung hinausgehend zwischenzuspeichern, und mit Adressengebern, die zur Ansteuerung eines Schaltelementes seine Adresse vollständig, d.h. deren erste und zweite Hälfte abgeben, und mit je einem zwischen einen Adressengeber und eine Schalteinrichtung geschalteten Multiplexer, der taktgleich mit der Schalteinrichtung gesteuert eine vom Adressengeber gesteuerte Adresse in die zwei Hälften aufteilt und diese einzeln in den beiden Zeitlagen über ein und denselben Adressen Übertragungsweg nacheinander an die Schalteinrichtung weiterleitet.

Schalteinrichtungen dieser Art sind bereits bekannt durch den Katalog "DATA BOOK MEMORY PRODUCTS 1987", der Firma NEC, Seite 169 ff. Schalteinrichtungen dieser Art können z.B. Speicher sein. Es besteht häufig das Erfordernis, in einem Speicher eine Anzahl von Speicherelementen (Schaltelementen) sukzessive nacheinander anzusteuern, wobei diese Speicheelemente sich auch hinsichtlich der Ansteuerungsadressen systematisch aneinander anschließen. Diese den einzelnen Speicherelementen zugeordneten Adressen von sukzessive nacheinander anzusteuernden Speicherelementen mögen sich nur dadurch voneinander unterscheiden, daß jeweils nur die zweite Adressenhälfte von Adresse zu Adresse verschieden ist, jedoch nicht die erste Adressenhälfte bei diesen mehreren Adressen. Deshalb ist es bereits im bekannten Falle vorgesehen, daß die betreffenden Schalteinrichtungen jeweils die erste Adressenhälfte auch über mehrere Ansteuerungsvorgänge (mehrere Ansteueradressen) hinweg zu speichern in der Lage sind. Diese Schalteinrichtungen nehmen eine solche Speicherung vor, wenn sie hierzu vom Adressengeber beim Erhalt der ersten Adresse einer Serien-Ansteuerung eine entsprechende Zusatzinformation erhalten. Diese Zusatzinformation sagt also dem Speicher, daß die im Zusammenhang mit der ersten Adresse an ihn übergebene erste Adressenhälfte gültig sein soll auch für die nächsten Ansteuerungsvorgänge.

Ein Problem entsteht, wenn die von einem Adressengeber im Zuge einer Serien-Ansteuerung sukzessive nacheinander abgegebenen Adressen sich nicht jeweils in dem Inhalt der zweiten Adressenhälfte sondern im Inhalt der jeweiligen ersten Adressenhälfte voneinander unterscheiden. Unter dieser Voraussetzung kann der Vorteil von Schalteinrichtungen der eingangs angegebenen bekannten Art nicht nutzbar gemacht werden, der bekanntlich darin besteht, daß bei einer Serien-Ansteuerung die vom Speicher aufgenommene jeweilige erste Adressenhälfte gültig ist für eine Reihe von anschließend sukzessive nacheinander folgenden Ansteuerungsvorgängen; dadurch, daß hierbei die erste Adressenhälfte nur einmal zum Speicher hin übertragen werden muß und dann gültig ist für eine ganze Reihe von Ansteuerungsvorgängen, wird der Zeitaufwand für die Ansteuerung insgesamt ganz wesentlich verringert.

Für die Erfindung besteht die Aufgabe, den zuvor angegebenen Vorteil in einer Schaltungsanordnung der eingangs angegebenen Art nutzbar zu machen auch unter geänderten Voraussetzungen derart, daß sich bei einer Folge von zu einer Serien-Ansteuerung gehörenden Ansteuerungsvorgängen die Adressen dadurch voneinander unterscheiden, daß jeweils die zweite Adressenhälfte für mehrere sukzessive aufeinanderfolgende Ansteuerungsvorgänge gleichbleibend ist.

Die Erfindung löst die ihr gestellte Aufgabe dadurch, daß bei einer Betriebsweise, gemäß der in einer Serien-Ansteuerung die zweiten Hälften der betreffenden Adressen gleichbleibend sind und sich nur die entsprechenden ersten Adressenhälften sukzessive von Ansteuerungsvorgang zu Ansteuerungsvorgang verändern, der Multiplexer die beiden Adressenhälften jeder der vom Adressengeber empfangenen Adressen vertauscht und dementsprechend jeweils die zweite Adressenhälfte in der ersten Zeitlage und die erste Adressenhälfte in der zweiten Zeitlage an die Schalteinrichtung weitergibt, wobei bei einer Serien-Ansteuerung sich diese Weitergabe, beginnend mit der zweiten Adresse, auf die ersten Adressenhälften jeweils in der zweiten Zeitlage beschränkt.

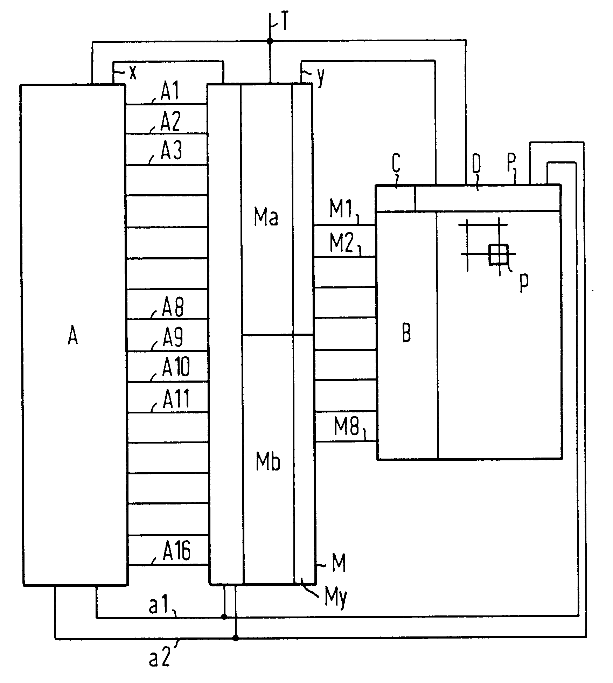

In der Zeichnung ist ein Ausführungsbeispiel der Erfindung nur in wesentlich zu ihrem Verständnis beitragenden Bestandteilen dargestellt.

Es ist eine Schalteinrichtung P vorgesehen, die im vorliegenden Falle ein Speicher ist. Die dargestellte Schaltungsanordnung ist Bestandteil einer Fernsprechvermittlungsanlage. Der Speicher ist in an sich bekannter Weise koordinatenförmig aufgebaut. Die Schalteinrichtung kann aber auch ein Koppelvielfach, eine Anzeigeeinrichtung o.dgl. sein, im vorliegenden Falle jedoch ein Speicher. An Kreuzungspunkten von Zeilen und Spalten befinden sich Schaltelemente p, z.B. Speicherelemente, in einer großen Anzahl. Diese Schaltelemente sind aufgrund ihrer koordinatenförmigen Anordnung in Zeilen und Spalten mittels Adressen in an sich bekannter Weise ansteuerbar. Hierzu besteht eine Adresse aus zwei Hälften. Eine Hälfte der jeweiligen Adresse dient zur Bestimmung der betreffenden Zeile und eine andere Hälfte der Adresse zur Bestimmung der jeweiligen Spalte (oder umgekehrt) des betreffenden Schaltelementes. Die Ansteuerung eines Speicherelementes kann in an sich bekannter Weise dem Zweck dienen, in ihm eine Information zu speichern (Schreiben) oder eine gespeicherte Information wieder zu gewinnen (Lesen). Ebenso kann eine Ansteuerung eines Speicherelementes auch dem Zweck dienen, eine gespeicherte Information zu lesen, um sie anschließend wieder zu speichern (refresh).

Speicher der hier beschriebenen Art sind an sich bekannt, wozu auf die bereits einleitend angegebene Literatur hingewiesen wird. Solche Speicher nehmen eine Adresse in zwei Hälften nacheinander auf. Eine erste Hälfte einer Adresse wird in einer ersten Zeitlage aufgenommen und eine zweite Hälfte derselben Adresse in einer zweiten Zeitlage. Die Adresse zur Ansteuerung jeweils eines Schaltelementes sowie zeitliche Markierungen für diese beiden Zeitlagen erfolgen von einem Adressengeber A her. Die zeitliche Markierung der beiden Zeitlagen erfolgt über Markierleitungen a1 (erste Zeitlage) und a2 (zweite Zeitlage).

Die Aufteilung einer Adresse in zwei Hälften kann exakt einer Halbierung entsprechen. Besteht eine Adresse zum Beispiel aus einem Codezeichen von insgesamt 32 Bit, so kann die erste Adressenhälfte 16 Bit und die zweite Adressenhälfte ebenfalls 16 Bit umfassen. Die Aufteilung in zwei Hälften kann aber auch hiervon abweichen, z.B. in der Weise, daß die erste "Hälfte" 20 Bit umfaßt, während die zweite "Hälfte" nur 12 Bit umfaßt (oder umgekehrt). Der Begriff "Hälfte" ist also hier in sehr weitem Sinne zu fassen, z.B. kann es hierbei auch um eine Unterteilung in zwei nur in etwa gleich große Teile gehen.

Der Speicher P enthält eine interne Steuerschaltung D, einen Adressenempfänger B und einen Adressenspeicher C. Die interne Steuerschaltung D empfängt über die Markierleitungen al und a2 die beiden bereits erwähnten Zeitmarkierungen für die erste Zeitlage und für die zweite Zeitlage. Außerdem erhält die interne Steuerschaltung D über eine gemeinsame Taktleitung T einen gemeinsamen Steuertakt, der auch dem Adressengeber A und einem Multiplexer M zugeführt wird.

Wie bereits erläutert wurde, erhält der Speicher P jeweils eine Adresse über seinen Eingang nacheinander in zwei Hälften in einer einer ersten Hälfte entsprechenden ersten Zeitlage und in einer einer zweiten Hälfte entsprechenden zweiten Zeitlage. An diesen Eingang ist eine acht Leitungsadern M1 bis M8 umfassende Adressierleitung angeschlossen. Der Eingang ist durch eine Eingangsschaltung im Adressenempfänger B des Speichers P realisiert. Die Adressierleitung (M1 bis M8) dient zur Übertragung der die Adresse bildenden Information in codierter Form. Dadurch, daß jeweils eine Adresse nacheinander in zwei Hälften (d h. in zwei gleich großen oder nur ungefähr gleich großen Teilen) in den beiden Zeitlagen nacheinander übertragen wird, ergibt sich die hier genutzte Möglichkeit, die Adressierleitung pro Ansteuerungsvorgang je zweimal auszunutzen - oder anders ausgedrückt - die Adressierleitung mit nur halb so vielen Leitungsadern auszustatten, wie vom Adressengeber jeweils gleichzeitig abgegebene Bits pro Adresse vorgesehen sind. Diese Zusammenhänge sind bereits bekannt (siehe die eingangs angegebene Literaturstelle).

Der Speicher enthält u.a. auch den zu seiner Speichersteuerung D gehörenden Adressenspeicher C. Letzterer dient dazu, die jeweils in der ersten Zeitlage bei einem Ansteuerungsvorgang aufgenommene erste Hälfte einer Adresse wenigstens bis zur zweiten Zeitlage desselben Ansteuerungsvorganges zwischenzuspeichern; bei anschließendem Empfang der jeweils zweiten Adressenhälfte erfolgt dann mittels dieser und mittels der zwischengespeicherten ersten Adressenhälfte die Ansteuerung des betreffenden Schaltelementes gemäß der gesamten Adresse.

Wie bereits ausgeführt wurde, ist auch ein Adressengeber A vorgesehen. Dieser kann Bestandteil eines Prozessors sein, der darüber hinaus auch noch eine größere Anzahl weiterer, hier nicht im einzelnen beschriebener bekannter Funktionen erfüllt. Der Adressengeber gibt zur Ansteuerung eines Schaltelementes dessen Adresse vollständig, d.h. deren erste und zweite Hälfte ab. Dies geschieht über eine aus Leitungsadern A1 bis A16 bestehende Adreßleitung. Der Adressengeber liefert die vollständige Adresse zunächst an einen Multiplexer M. Sämtliche Bits einer Adresse werden gleichzeitig vom Adressengeber A an den Multiplexer M geliefert.

Der Multiplexer M ist also zwischen den Adressengeber und den Speicher P geschaltet. Er wird taktgleich mit dem Speicher M gesteuert. Ein gemeinsamer Steuertakt wird über die Taktleitung T dem Adressengeber A, dem Multiplexer M und dem Speicher P zugeführt. - Der Multiplexer M teilt eine vom Adressengeber gesteuerte Adresse (Gesamt-Adresse) in die genannten zwei Hälften auf und leitet diese einzeln in den beiden Zeitlagen über ein und dieselbe Adressierleitung, also über ein und denselben Übertragungsweg (Leitungsadern M1 bis M8) nacheinander an den Speicher P weiter. Auf diese Weise bewirkt der Adressengeber A eine Ansteuerung von Schaltelementen p im Speicher P in an sich bekannter Weise. Dabei liefert der Adressengeber sowohl die vollständige Adresse, als auch die beiden Zeitmarkierungen, die die genannten beiden Zeitlagen angeben. Diese Zeitmarkierungen werden auch dem Multiplexer M zugeführt, und zwar seiner Multiplexersteuerung Mx. Die vollständige Adresse wird vom Adressengeber A zwei Schaltgliedern Ma und Mb zugeführt. Dem Schaltglied Ma wird die erste Hälfte der Adresse und dem Schaltglied Mb die zweite Hälfte der Adresse zugeführt. Die Multiplexersteuerung Mx bewirkt, daß in der ersten Zeitlage die erste Hälfte der Adresse über das Schaltglied Ma und in der zweiten Zeitlage die zweite Hälfte der Adresse über das Schaltglied Mb dem Eingang (B) des Speichers P zugeführt wird (über M1 bis M8). Hierzu ist eine Ausgabeeinrichtung My im Multiplexer M vorgesehen. Die interne Steuerschaltung D liefert über eine Quittungssignal-Leitung y jedesmal nach Empfang einer Adressenhälfte und deren Speicherung im Adressenspeicher C ein Quittungssignal an den Multiplexer wodurch dieser nach Empfang einer ersten Adressenhälfte bei Ansteuerung eines Speicherelementes veranlaßt wird, die zweite Adressenhälfte anstelle der ersten über die Adressierleitung (M1 bis M8) an den Eingang B des Speichers P anzulegen. Ferner wird im Multiplexer eine dem Quittungssignal entsprechende Information von der Ausgabeeinrichtung My zur Multiplexersteuerung Mx gegeben, aufgrund deren über eine Quittungszeichenleitung x ein Quittungszeichen zum Adressengeber übertragen wird. Dieser gibt dann die Zeitlagenmarkierung für die zweite Zeitlage (wie oben beschrieben) ab, woraufhin der Speicher die zweite Adressenhälfte über die Adressierleitung (M1 bis M8) aufnimmt. Auch hierauf werden Quittungssignal und Quittungszeichen übertragen, woraufhin die nächste Adresse in der gleichen Weise vom Adressengeber über den Multiplexer zum Speicher übermittelt wird.

Wie weiterhin bereits bekannt ist, kann auch eine Serien-Ansteuerung mehrerer Schaltelemente nacheinander vorgenommen werden, die sich bei gleichbleibendem Inhalt jeweils der ersten Adressenhälfte nur durch den Inhalt der jeweils zweiten Adressenhälfte voneinander unterscheiden. Dies können z.B. die Schaltelemente bzw. die Speicherelemente sein, die sich im Speicher P in einer Zeile oder in einer Spalte befinden. Befinden sich bei einer Serien-Ansteuerung die betreffenden Speicherelemente z.B. in einer Zeile, so sind diejenigen Teile der Ansteuerungsadressen für diese Speicherelemente gleich, die Information über die Zeile enthalten; diese Speicherelemente unterscheiden sich also lediglich darin, daß in ihren Ansteuerungsadressen die die Spalten betreffenden Adressenbestandteile unterschiedlich sind. Bei einer Serien-Ansteuerung kann deshalb die ein erstes Mal übertragene Zeileninformation (um bei dem gleichen Beispiel zu bleiben) immer wieder neu zur Ansteuerung der mehreren Speicherelemente sukzessive nacheinander verwendet werden. - Findet nun eine Serien-Ansteuerung (z.B. in einer Zeile) statt, so gibt der Adressengeber zusätzlich eine diese Serien-Ansteuerung anzeigende Zusatzinformation für die Dauer der Serien-Ansteuerung ab. Diese Zusatz-Information kann vorzugsweise darin bestehen, daß über diejenige Zeitlagen-Markierleitung (z.B. al), über die die erste Zeitlage markiert wird, z.B. mittels eines entsprechenden Potentialwechsels, auch diese Serien-Ansteuerung signalisiert wird, z.B. dadurch, daß dieser Potentialwechsel für die Dauer dieser Serien-Ansteuerung bestehen bleibt, wobei das Ende dieser Serien-Ansteuerung dadurch angezeigt werden möge, daß dieser Potentialwechsel dann wieder rückgängig gemacht wird.

Sowohl der Multiplexer M als auch der Speicher P erhalten diese Zusatzinformation, z.B. über die Markierleitung al. Aufgrund dieser Zusatzinformation speichert der Speicher P in seinem Adressenspeicher C die erste Hälfte der mit einer Serien-Ansteuerung erhaltenen Adresse; diese erste Hälfte der ersten Adresse einer Serien-Ansteuerung wird vom Speicher P in der ersten Zeitlage aufgenommen. Der Speicher P speichert diese erste Hälfte der ersten Adresse mit seinem Adressenspeicher C und bewahrt diese erste Hälfte darin solange auf, wie die Zusatz-Information über die Markierleitung al anliegt, also für die Dauer der betreffenden Serien-Ansteuerung. Er gibt nach dieser Speicherung das Quittungssignal - wie zuvor beschrieben - ab.

Der Adressengeber A gibt im bekannten Falle bei einer Serien-Ansteuerung in deren erstem Ansteuerungsvorgang die vollständige Adresse quittungsgesteuert an den Multiplexer ab, und dieser leitet nacheinander in den beiden Zeitlagen die erste Hälfte sowie die zweite Hälfte der betreffenden Adresse in der beschriebenen Weise quittungsgesteuert an den Speicher weiter. Beginnend mit dem zweiten Ansteuerungsvorgang bei derselben Serien-Ansteuerung gibt im bekannten Falle der Adressengeber von jeder neuen Adresse immer die erste Hälfte und die zweite Hälfte an den Multiplexer M hin - ebenfalls quittungsgesteuert - ab und der Multiplexer liefert bei jedem Ansteuerungsvorgang immer nur die zweite Hälfte der betreffenden Ansteuerungsadressen an den Speicher P weiter. Aufgrund der Serien-Ansteuerung, die der Adressengeber A mittes der erwähnten Zusatz-Information signalisiert, erübrigt sich - beginnend jeweils mit der zweiten Adresse - die Übertragung der ersten Adressenhälfte vom Multiplexer M an den Speicher C. Dieser quittiert also - beginnend jeweils mit der zweiten Adresse - immer die jeweils übertragene zweite Adressenhälfte (und wegen Vorliegens der Zusatzinformation diese zweite Adressenhälfte!), woraufhin der Markierer aufgrund des vom Speicher empfangenen Quittungs-Signales das entsprechende Quittungszeichen an den Adressengeber A abgibt, woraufhin dieser dann die momentan abgegebene Adresse (über A1 bis A16) durch die jeweils nächstfolgende Adresse auswechselt. Hierdurch wird bei Serien-Ansteuerung der gesamte Übertragungsprozeß wesentlich verkürzt. - Ebensogut könnte auch vorgesehen werden, daß der Adressengeber bei jedem Ansteuerungsvorgang einer Serien Ansteuerung zusammen mit der Zusatz-Information - beginnend mit dem zweiten Ansteuerungsvorgang - von vornherein immer nur die zweite Hälfte jeder dieser Adressen an den Multiplexer abgibt.

Die erfindungsgemäße Arbeitsweise des beschriebenen Ausführungsbeispiels geht davon aus, daß in einer Serien-Ansteuerung immer die zweiten Hälften der vom Adressengeber A abgegebenen Adressen gleichbleibend sind und daß sich nur die entsprechenden ersten Adressenhälften sukzessive von Ansteuerungsvorgang zu Ansteuerungsvorgang verändern. Erfindungsgemäß ist deshalb vorgesehen, daß der Multiplexer M die beiden Adressenhälften jeder der vom Adressengeber empfangenen Adressen vertauscht. Für den Multiplexer M ist dann demzufolge die jeweilige erste Adressenhälfte derjenige Teil, der über die Leitungsadern A9 bis A16 der Adreßleitung übertragen wird; und die zweite Hälfte ist dann derjenige Teil, der über die Adressenleitungen A1 bis A8 übertragen wird. Der Multiplexer gibt also jeweils die zweite Adressenhälfte, die er über die Leitungsadern A9 bis A16 erhält, in der ersten Zeitlage an den Speicher P weiter und die erste Adressenhälfte, die er über die Adressenleitungen A1 bis A8 erhält, in der zweiten zeitlage an den Speicher P weiter. Dabei ist - beginnend mit der zweiten Adresse der jeweils betreffenden Serien-Ansteuerung - diese Weitergabe auf die ersten Adressenhälften beschränkt, die also jeweils in der zweiten Zeitlage übertragen werden. Genauer gesagt, gibt es bei einer Serien-Ansteuerung - beginnend mit der jeweils zweiten Adresse - für den Speicher P im Hinblick auf die Zeitlagen-Markierung überhaupt nur noch zweite Zeitlagen. Diese Übertragungsvorgänge erfolgen ebenfalls quittungsgesteuert in einer dem zuvor Beschriebenen entsprechenden Weise, und ebenfalls mit der vorteilhaften Folge, daß der gesamte Übertragungsprozeß wesentlich verkürzt ist bei Serien-Ansteuerung.

Der Speicher P, dem auch die genannte Zusatz-Information zugeführt wird, erhält bei einer Serien-Ansteuerung diese Zusatzinformation und - beginnend mit der zweiten Adresse - immer nur noch die ersten Adressenhälften jeder der nacheinander vom Adressengeber A abgegebenen Adressen, sowie die Zeitmarkierung für die jeweils zweite Zeitlage. Der Speicher P quittiert empfangene Adressenhälften (über y) in der beschriebenen Weise an den Multiplexer. Dieser quittiert (über x) aufgrund der Zusatzinformation - beginnend bei einer Serienansteuerung mit der jeweils zweiten Adresse von ihr - aufgrund der bei der Serien-Ansteuerung erhaltenen Zusatzinformation gegenüber dem Adressengeber A den Erhalt und die Weitergabe der jeweiligen Adresse; er erhält also zunächst über y das Quittungssignal vom Speicher P nach hierin erfolgtem Empfang der in der zweiten Zeitlage erhaltenen ersten Adressenhälfte und nach deren erfolgter Speicherung im Adressenspeicher C, und gibt dann hierauf und aufgrund des Vorliegens der Zusatz-Information das Quittungszeichen (also nicht das Quittungssignal, sondern das ihm entsprechende Quittungszeichen !) über x an den Adressengeber A. Dieser sendet dann anstelle der über A1 bis A16 momentan noch abgegebenen Adresse die jeweils nächstfolgende Adresse an den Multiplexer M. Es wird also ebenfalls der gesamte Übertragungsprozeß erheblich verkürzt, weil eine Weiterleitung der zweiten Adressenhälfte - beginnend jeweils mit der zweiten Adresse einer Serien-Ansteuerung - hierbei entfällt. Der Speicher P nimmt mit seiner Speichersteuerung D eine Ansteuerung der einzelnen Speicherelemente p nacheinander dadurch vor, daß er für die Ansteuerungsvorgänge einer Serien-Ansteuerung nacheinander für die Ansteuerung der verschiedenen Speicherelemente p immer die gleiche zweite Adressenhälfte verwendet, die ihm beim ersten Ansteuerungsvorgang dieser Serien-Ansteuerung übertragen worden ist, und die er in seinem Adressen-speicher C gespeichert hat. Für die verschiedenen Ansteuerungsvorgänge einer Serien-Ansteuerung verwendet der Speicher P außer der dabei gleichbleibenden zweiten Adressenhälfte einzeln nacheinander in seiner Speichersteuerung D zur Ansteuerung der verschiedenen Speicherelemente außerdem die einzelnen, sich voneinander unterscheidenden ersten Adressenhälften, die ihm mit der jeweils zweiten Zeitlagenmarkierung nacheinander zugeleitet werden.

Durch die Erfindung wird die Möglichkeit geschaffen, solche Speicher, die jeweils eine Adresse über einen Eingang nacheinander in zwei Hälften, und zwar in einer einer ersten Hälfte entsprechenden ersten Zeitlage und in einer einer zweiten Hälfte entsprechenden zweiten Zeitlage aufnehmen, und die jeweils die in der ersten Zeitlage aufgenommene erste Hälfte zwischenzuspeichern vermögen, und in denen bei anschließendem Empfang der zweiten Hälfte mittels dieser und der zwischengespeicherten ersten Hälfte die Ansteuerung des betreffenden Schaltelementes gemäß der Adresse erfolgt, und die bei einer Serien-Ansteuerung nacheinander von mehreren Schaltelementen, die sich bei gleichbleibendem Inhalt der ersten Adressenhälfte nur durch den Inhalt der jeweils zweiten Adressenhälfte unterscheiden, und die eine diese Serien-Ansteuerung anzeigende Zusatzinformation sowie von denjenigen Adressen, die zu einer Serien-Ansteuerung gehören, nur die jeweilige zweite Adressenhälfte erhalten und durch diese Zusatzinformation veranlaßt werden, die erste Hälfte der bei dieser Serien-Ansteuerung aufgenommenen Adresse über die erste Ansteuerung bei dieser Serien-Ansteuerung hinausgehend zwischenzuspeichern, auch bei einer solchen Betriebsweise verwenden zu können, gemäß der in einer Serien-Ansteuerung sich die einzelnen Adressen für die Ansteuerungs-Vorgänge für die einzelnen Speicherelemente dadurch voneinander unterscheiden, daß die ersten (statt - wie bekannt - die zweiten) Adressenhälften dieser Adressen verschieden sind und daß die zweiten (statt - wie bekannt - die ersten) Adressen-Hälften dieser Adressen untereinander gleich sind. Hierzu vertauscht der Multiplexer M die beiden Adressenhälften jeder der vom Adressengeber empfangenen Adressen und gibt sie in der bereits beschriebenen Weise an den Speicher P weiter. Diese Vertauschung kann darin bestehen, daß die Adreßleitungen A1 bis A8 vertauscht mit den Adreßleitungen A9 bis A16 an den Multiplexer M angeschlossen sind. Hierbei kann die Reihenfolge bezüglich der Adreßleitungen A1 bis A8 einerseits und A9 bis A16 andererseits beibehalten sein, oder sie kann auch zusätzlich umgekehrt sein. Im letzteren Falle wäre dann also die Adreßleitung A1 am Multiplexer M dort angeschlossen, wo im bekannten Falle die Adreßleitung A 16 angeschlossen ist, und die letztere wäre am Multiplexer M dort angeschlossen, wo im bekannten Falle die Adreßleitung A1 angeschlossen ist. - Die genannte Vertauschung kann aber auch darin bestehen, daß lediglich der Ablauf der Funktionsvorgänge im Multiplexer M vertauscht wird, und zwar in der Weise, daß bei einer Serien-Ansteuerung jeweils in der ersten Zeitlage das Schaltglied Mb die zweite Adressenhälfte von den Adreßleitungen A9 bis A16 auf die Leitungsadern M1 bis M8 weitergibt, und daß der Multiplexer in der zweiten Zeitlage die erste Adressenhälfte von den Leitungsadern A1 bis A8 der Adreßleitung ebenfalls auf die Leitungsadern M1 bis M8 der Adressierleitung weitergibt, d.h. zur Eingangsschaltung B des Speichers P und daß - beginnend mit der zweiten Adresse - jeweils nur noch die erste Adressenhälfte in der Weise weitergegeben wird. - Die genannte Vertauschung kann auch dadurch bewerkstelligt werden, daß lediglich die beiden Markierleitungen a1 und a2 am Adressengeber A vertauscht angeschlossen sind.

## Patentansprüche

1. Schaltungsanordnung für Fernmeldevermittlungsanlagen, insbesondere Fernsprechvermittlungsanlagen,
mit jeweils eine Vielzahl von mittels Adressen ansteuerbaren, insbesondere koordinatenförmig angeordneten Schaltelementen (p) umfassenden Schalteinrichtungen (P),
die jeweils eine Adresse (A1-A16) über einen Eingang (M1-M8) nacheinander in zwei Hälften, in einer einer ersten Hälfte (A1-A8) entsprechenden ersten Zeitlage und in einer einer zweiten Hälfte (A9-A16) entsprechenden zweiten Zeitlage, aufnehmen,
und die jeweils die in der ersten Zeitlage aufgenommene erste Hälfte wenigstens bis zur zweiten Zeitlage zwischenspeichern,
und in denen bei anschließendem Empfang der zweiten Hälfte mittels dieser und der zwischengespeicherten ersten Hälfte die Ansteuerung des betreffenden Schaltelementes (p) gemäß der Adresse (A1-A16) erfolgt,
und die bei einer Serien-Ansteuerung nacheinander von mehreren Schaltelementen, die sich bei gleichbleibendem Inhalt der ersten Adressenhälfte (A1-A8) nur durch den Inhalt der jeweils zweiten Adressenhälfte (A9-A16) unterscheiden, eine diese Serien-Ansteuerung anzeigende Zusatz-Information, (a1, a2) sowie von denjenigen Adressen, die zu einer Serien-Ansteuerung gehören, nur die jeweilige zweite Adressenhälfte erhalten und durch diese Zusatz-Information veranlaßt werden, die erste Hälfte der bei dieser Serien-Ansteuerung aufgenommenen Adresse über die erste Ansteuerung bei dieser SerienAnsteuerung hinausgehend zwischenzuspeichern,
und mit Adressengebern (A), die zur Ansteuerung eines Schaltelementes (p) seine Adresse (A1-A16) vollständig, d.h. deren erste und zweite Hälfte abgeben,
und mit je einem zwischen einen Adressengeber (A) und eine Schalteinrichtung (P) geschalteten Multiplexer (Ma, Mb), der taktgleich mit der Schalteinrichtung gesteuert eine vom Adressengeber ausgegebene Adresse in die zwei Hälften (A1-A8, A9-A16) aufteilt und diese einzeln in den beiden Zeitlagen über ein und denselben Adressen-Übertragungsweg nacheinander an die Schalteinrichtung weiterleitet,
**dadurch gekennzeichnet,**
daß bei einer Betriebsweise, gemäß der in einer Serien-Ansteuerung die zweiten Hälften (A9-A16) der betreffenden Adressen gleichbleibend sind und sich nur die entsprechenden ersten Adressenhälften (A1-A8) sukzessive von Ansteuerungsvorgang zu Ansteuerungsvorgang verändern, der Multiplexer (Ma, Mb) die beiden Adressenhälften jeder der vom Adressengeber empfangenen Adressen vertauscht und dementsprechend jeweils die zweite Adressenhälfte in der ersten Zeitlage und die erste Adressenhälfte in der zweiten Zeitlage an die Schalteinrichtung weitergibt, wobei bei einer Serien-Ansteuerung sich diese Weitergabe, beginnend mit der zweiten Adressenhälfte, auf die ersten Adressenhälften jeweils in der zweiten Zeitlage beschränkt.

2. Schaltungsanordnung nach Anspruch 1,
**dadurch gekennzeichnet,**
daß der Adressengeber (A) bei einer Serien-Ansteuerung, beginnend mit der zweiten Adressenhälfte, von jeder Adresse nur die jeweils erste Adressenhälfte abgibt.

3. Schaltungsanordnung nach Anspruch 1,
**dadurch gekennzeichnet,**
daß von dem Adressengeber (A) zu dem Multiplexer (Ma, Mb) führende Adreßleitungen (A1-A16) entsprechend den zwei Adressenhälften (A1-A8, A9-A16) in zwei Gruppen unterteilt sind und daß die Adreßleitungen der beiden Gruppen vertauscht an den Multiplexer angeschaltet sind.

4. Schaltungsanordnung nach Anspruch 1,
**dadurch gekennzeichnet,**
daß zwei den beiden Zeitlagen einzeln zugeordnete Zeitlage-Markierungen (a1, a2), die vom Adressengeber (A) zum Multiplexer (Ma, Mb) und zu der Schalteinrichtung (P) geführt sind, am Adressengeber vertauscht angeschlossen sind.

5. Schaltungsanordnung für Schalteinrichtungen, die nach Empfang von Adressenhälften jeweils ein Quittungssignal (x, y) zurückgeben nach Anspruch 1,
**dadurch gekennzeichnet,**
daß bei Empfang einer vom Adressengeber (A) abgegebenen, ein Serien-Ansteuerung signalisierenden Zusatz-Information in der Schalteinrichtung ein Quittungssignal (über y) für den Erhalt der ersten Adressenhälfte erzeugt wird und an den Multiplexer (M) abgegeben wird,
und daß dieser - beginnend jeweils mit der zweiten Adressenhälfte bei einer Serien-Ansteuerung - aufgrund der vorliegenden Zusatz-Information und des erhaltenen Quittungssignales (über y) ein Quittungszeichen (über x) an den Adressengeber überträgt, welches die Erledigung jeweils einer mittels einer Adresse erfolgten Adressierung in der Schalteinrichtung (P) anzeigt und eine in der betreffenden Serien-Ansteuerung jeweils nächstfolgende Adresse von dem Adressengeber an fordert.

## Claims

1. Circuit arrangement for telecommunication exchanges, in particular telephone exchanges, having switching devices (P) comprising in each case a multiplicity of address-controlled switching elements (p) which are arranged, in particular, in the manner of coordinates, and
which respectively receive an address (A1-A16) via an input (M1-M8), doing so successively in two halves, in a first time slot corresponding to a first half (A1-A8) and in a second time slot corresponding to a second half (A9-A16),
and which respectively buffer the first half received in the first time slot, at least up to the second time slot,
and in which upon subsequent reception of the second half use the latter and the buffered first half to drive the relevant switching element (p) in accordance with the address (A1-A16),
and which in the case of successive serial driving of a plurality of switching elements which, given a constant content of the first address half (A1-A8), differ from one another only in the content of the respective second address half (A9-A16), receive both an additional information item (a1, a2), indicating this serial drive, and, from those addresses which belong to a serial drive, only the respective second address half and are caused by this additional information item to buffer beyond the first drive in the case of this serial drive the first half of the address received during this serial drive,
and having address generators (A) which for the purpose of driving a switching element (p) output its address (A1-A16) completely, that is to say their first and second halves,
and having respectively one multiplexer (Ma, Mb) which is connected between an address generator (A) and a switching device (P) and, in a manner controlled in time with the switching device, divides an address output by the address generator into the two halves (A1-A8, A9-A16) and successively relays the latter individually to the switching device in the two time slots via one and the same address transmission path, characterized in that, in a mode of operation in accordance with which the second halves (A9-A16) of the relevant addresses are constant in a serial drive and only the corresponding first address halves (A1-A8) are successively varied from drive operation to drive operation, the multiplexer (Ma, Mb) interchanges the two address halves of each of the addresses received by the address generator and correspondingly respectively relays the second address half to the switching device in the first time slot and the first address half in the second time slot, it being the case that in a serial drive this relay is respectively limited in the second time slot to the first address halves, starting with the second address half.

2. Circuit arrangement according to Claim 1, characterized in that in a serial drive, the address generator (A) outputs only the respective first address half of each address, starting with the second address half.

3. Circuit arrangement according to Claim 1, characterized in that address lines (A1-A16) leading from the address generator (A) to the multiplexer (Ma, Mb) are subdivided into two groups in accordance with the two address halves (A1-A8, A9-A16), and in that the address lines of the two groups are connected to the multiplexer in an interchanged manner.

4. Circuit arrangement according to Claim 1, characterized in that two time slots marks (a1, a2) which are individually assigned to the two time slots and are led from the address generator (A) to the multiplexer (Ma, Mb) and to the switching device (P) are connected to the address generator in an interchanged manner.

5. Circuit arrangement for switching devices according to Claim 1 which respectively return an acknowledgement signal (x, y) after receiving address halves, characterized in that upon receipt of an additional information item, output by the address generator (A) and signalling a serial drive, an acknowledgement signal is generated (via y) in the switching device for the reception of the first address half and is output to the multiplexer (M), and in that - starting respectively with the second address half in a serial drive - on the basis of the available additional information item and of the acknowledgement signal received (via y) said multi-plexer transmits (via x) to the address generator an acknowledgement character which indicates the completion of respectively one addressing operation performed in the switching device (P) by means of an address and requests from the address generator an address which respectively follows next in the relevant serial drive.

## Revendications

1. Montage pour des installations de commutation de télécommunications, notamment des installations de commutation téléphoniques, comportant
des dispositifs de commutation (P), qui comprennent chacun une multiplicité d'éléments de commutation (p), pouvant être commandés au moyen d'adresses et disposés notamment suivant des coordonnées,
qui reçoivent chacun une adresse (A1 à A16) par l'intermédiaire d'une entrée (M1 à M8), successivement en deux moitiés, dans une première plage temporelle correspondant à une première moitié (A1 à A8) et dans une seconde plage temporelle correspondant à une seconde moitié (A9 à A16), et
qui mémorisent temporairement chacun la première moitié, reçue dans la première plage temporelle, au moins jusqu'à la seconde plage temporelle, et
dans lesquels, lors de la réception ensuite de la seconde moitié, la commande de l'élément de commutation (p) considéré s'effectue suivant l'adresse (A1 à A16) au moyen de cette seconde moitié et de la première moitié mémorisée temporairement,
et qui reçoivent, dans le cas d'une commande en série successive de plusieurs éléments de commutation, qui ne diffèrent, pour un même contenu de la première moitié d'adresses (A1 à A8), que par le contenu de la seconde moitié respective d'adresse (A9 à A16), une information supplémentaire (a1,a2) indiquant cette commande en série, ainsi que, de celles des adresses, qui font partie d'une commande en série, uniquement la seconde moitié des adresses, et qui sont commandés, par cette information supplémentaire, pour mémoriser temporairement la première moitié des adresses, reçue lors de cette commande en série, au-delà de la première commande lors de cette commande en série,
des générateurs d'adresses (A), qui fournissent, pour la commande d'un élément de commutation (p), son adresse complète (A1 à A16), c'est-à-dire la première moitié et la seconde moitié de cette adresse, et
respectivement un multiplexeur (Ma, Mb), qui est branché entre un générateur d'adresses (A) et un dispositif de commutation (B) et qui, en étant commandé à la même cadence que le dispositif de commutation, subdivise une adresse fournie par le générateur d'adresses, en les deux moitiés (A1 à A8, A9 à A16) et retransmet successivement ces moitiés individuellement dans les deux plages temporelles au dispositif de commutation, par l'intermédiaire d'une même voie de transmission d'adresses,
caractérisé par le fait
que dans un mode de fonctionnement, selon lequel lors d'une commande en série, les secondes moitiés (A9 à A16) des adresses considérées restent les mêmes et seules les premières moitiés correspondantes d'adresse (A1 à A8) varient successivement d'opération de commande en opération de commande, le multiplexeur (Ma, Mb) permute les deux moitiés d'adresse de chacune des adresses reçues par le générateur d'adresses et retransmet par conséquent la seconde moitié d'adresse dans la première plage temporelle et la première moitié d'adresse dans la seconde plage temporelle au dispositif de commutation, cette retransmission étant limitée, lors d'une commande en série, en commençant par la seconde moitié d'adresse, aux premières moitiés d'adresses dans la seconde plage temporelle.

2. Montage suivant la revendication 1, caractérisé par le fait que dans le cas d'une commande en série, en commençant par la seconde moitié d'adresse, le générateur d'adresses (A) ne fournit que la première moitié respective de chaque adresse.

3. Montage suivant la revendication 1, caractérisé par le fait que les lignes (A1 à A16) de transmission d'adresses, qui mènent du générateur d'adresses (A) au multiplexeur (Ma, Mb) sont subdivisées en deux groupes, suivant les deux moitiés d'adresses (A1 à A8, A9 à A16) et que les lignes de transmission d'adresses des deux groupes sont raccordées d'une manière permutée au multiplexeur.

4. Montage suivant la revendication 1, caractérisé par le fait que deux repères (a1, a2) de plages temporelles, qui sont associés respectivement aux deux plages temporelles et qui mènent du générateur d'adresses (A) au multiplexeur (Ma, Mb) et au dispositif de commutation (P), sont raccordés d'une manière permutée au générateur d'adresses.

5. Montage pour des dispositifs de commutation, qui après la réception de moitiés d'adresses, renvoient chacun un signal d'accusé de réception (x, y) suivant la revendication 1,
caractérisé par le fait
que, lors de la réception d'une information supplémentaire fournie par le générateur d'adresses (A) et signalant une commande en série, un signal d'accusé de réception (par l'intermédiaire de y) est produit, dans le dispositif de commutation, pour l'obtention de la première moitié d'adresse et est envoyé au multiplexeur (M), et
que - en commençant par la seconde moitié d'adresse lors d'une commande en série - ce multiplexeur transmet au générateur d'adresse, sur la base de l'information supplémentaire présente et du signal d'accusé de réception obtenu (par l'intermédiaire de y), un signe d'accusé de réception (par l'intermédiaire de x), qui indique l'exécution d'un adressage effectué au moyen d'une adresse, dans le dispositif de commutation (P), et qui exige du générateur d'adresses une adresse immédiatement suivante dans la commande en série considérée.
